(19) Europäisches Patentamt
European Patent Office
Office européen des brevets

(11) Veröffentlichungsnummer : **0 106 176**
**B1**

(12) **EUROPÄISCHE PATENTSCHRIFT**

(45) Veröffentlichungstag der Patentschrift : **20.08.86**

(21) Anmeldenummer : **83109160.8**

(22) Anmeldetag : **16.09.83**

(51) Int. Cl.[4] : **C 08 F 2/50**, G 03 C 1/68, C 09 D 11/10

(54) **Photopolymerisierbare Massen und ihre Verwendung.**

(30) Priorität : **29.09.82 DE 3236026**

(43) Veröffentlichungstag der Anmeldung : **25.04.84 Patentblatt 84/17**

(45) Bekanntmachung des Hinweises auf die Patenterteilung : **20.08.86 Patentblatt 86/34**

(84) Benannte Vertragsstaaten : **BE DE FR GB IT NL SE**

(56) Entgegenhaltungen :
**EP-A- 0 007 508**
**EP-A- 0 037 604**
**EP-A- 0 040 721**

(73) Patentinhaber : **BASF Aktiengesellschaft**
**Carl-Bosch-Strasse 38**
**D-6700 Ludwigshafen (DE)**

(72) Erfinder : **Henne, Andreas, Dr.**
**Bruesseler Ring 34**
**D-6700 Ludwigshafen (DE)**
Erfinder : **Schornick, Gunnar, Dr.**
**Konrad-Adenauer-Strasse 8**
**D-6719 Neuleiningen (DE)**

**EP 0 106 176 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die vorliegende Erfindung betrifft photopolymerisierbare Massen, die synergistisch wirkende Zusätze enthalten, sowie die Verwendung dieser Massen zur Herstellung von Überzügen, Photopolymerdruckplatten und UV-härtenden Druckfarben.

Aus EP 37 152 und EP 37 604 sind photopolymerisierbare Massen bekannt, die folgende vier Bestandteile enthalten :

a) einen Photoinitiator aus der Klasse der Acetophenonderivate und Benzophenone

b) ein olefinisch ungesättigtes Bindemittel

c) das $Na^-$, $K^-$ oder Li-Salz einer organischen Säure und

d) ein Lösungsmittel für Komponente c), vorzugsweise Wasser oder Alkohol.

Diesen Druckschriften ist zu entnehmen, daß eine starke Erhöhung der mit Komponente a) allein erreichbaren Härtungsgeschwindigkeiten von Oberflächenbeschichtungen an Luft durch den Zusatz der Komponenten c) und d) erreicht wird. Ein Nachteil dieser Massen ist jedoch, daß zur Lösung der Komponenten c) und d) sehr polare Bindemittel eingesetzt werden müssen. Das beschränkt die Auswahl der Bindemittel und der dadurch erreichbaren physikalischen Eigenschaften der Oberflächenbeschichtungen. Ferner weisen die in EP 37 152 und EP 37 604 eingesetzten Bindemittel hohe Toxizität auf.

Aufgabe der vorliegenden Erfindung ist es, photopolymerisierbare Massen aufzuzeigen, die diese Nachteile nicht aufweisen und insbesondere auch in pigmentiertem Zustand vorteilhaft verwendbar sind.

Es wurde gefunden, daß die Härtungsaktivität, welche mit den als Photoinitiatoren aus EP 42 567, DE-OS 28 30 927, DE-OS 29 09 994, DE-OS 30 20 092, DE-OS 30 34 697 sowie aus den deutschen Patentanmeldungen P 31 14 431 und P 31 33 419 bekannten Acylphosphinverbindungen erreicht werden kann, die nach EP 37 152 und EP 37 604 mit den dort beschriebenen Verbindungen erreichbare Härtungsgeschwindigkeit weit übersteigt. Dies ist in zweifacher Weise überraschend : einmal hinsichtlich der quantitativen Höhe der unter Zusatz von Komponente c) und d) erreichbaren Härtungsgeschwindigkeit ; zum zweiten auch insofern, als Acylphosphinverbindungen aufgrund der von Frey, Lisieck, Lindner und Vordermaier in Chem. Ber. *112*, S. 763-772 (1980) gemachten Angaben als äußerst empfindlich gegenüber solvolytischen Einflüssen gelten und man eine schnelle Zersetzung der Acylphosphinverbindungen durch hydroxylgruppenhaltige Lösungsmittel d) erwarten mußte.

Überraschend wurde ferner gefunden, daß eine Lösung der Komponenten c) und d) im Bindemittel nicht erforderlich ist. Vielmehr können die Komponenten c) und d) als Emulsion im Bindemittel eingesetzt werden. Dies erweitert die Auswahlmöglichkeit für das Bindemittel gegenüber den in EP 37 152 und EP 37 604 genannten wesentlich.

Gegenstand der vorliegenden Erfindung ist eine photopolymerisierbare Masse auf Basis eines Gemisches aus Photoinitiator, polymerisierbaren olefinisch ungesättigten organischen Verbindungen und weiteren Zusätzen, die dadurch gekennzeichnet ist, daß sie enthält

(a) als Photoinitiator eine Acylphosphinverbindung der allgemeinen Formel I

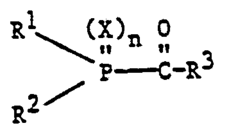

(I)

wobei

$R^1$ für einen geradkettigen oder verzweigten Alkyl- oder Alkenylrest mit bis zu 8 Kohlenstoffatomen, für einen geradkettigen oder verzweigten Alkoxy- oder Alkenyloxyrest mit bis zu 8 Kohlenstoffatomen, einen Cyclohexyl-, Cyclopentyl- oder Benzylrest, einen Cyclopentyloxy-, Cyclohexyloxy- oder Benzyloxyrest oder für einen bis zu dreifach substituierten Phenyl- oder Phenyloxyrest steht, wobei die Substituenten geradkettige oder verzweigte, bis zu 6 Kohlenstoffatome enthaltende Alkyl-, Alkoxy-, Alkylthio-, Dialkylaminogruppen oder Halogenatome mit einem Atomgewicht bis zu 80 sein können,

$R^2$ die gleiche Bedeutung wie $R^1$ hat, wobei $R^1$ und $R^2$ untereinander gleich oder verschieden sind, oder für die Gruppierung $NR^4R^5$ steht, wobei $R^4$ und $R^5$ untereinander gleich oder verschieden sind und für Wasserstoff, einen geradkettigen oder verzweigten Alkylrest mit bis zu 18 C-Atomen, einen Cyclohexyl-, Cyclopentylrest, einen Hydroxyalkylrest mit 2 bis 4 Kohlenstoffatomen oder einen Phenylrest stehen,

$R^3$ für einen tertiären Alkylrest mit 4 bis 18 C-Atomen, einen tertiären Cycloalkylrest mit 6 bis 18 C-Atomen oder für einen gegebenenfalls ein- bis vierfach substituierten Pyridyl-, Pyrrolyl-, Furyl-, Thienyl-, Phenyl- oder Naphthylrest steht, dessen Substituenten untereinander gleich oder verschieden sein können und bis zu 6 Kohlenstoffatome enthaltende, geradkettige oder verzweigte Alkyl-, Alkoxy- oder Alkylthio-Reste, 5 bis 7 Kohlenstoffatome enthaltende Cycloalkylreste, Phenylreste, Nitril-, Carboxyl-, Carboalkoxygruppen oder Halogenatome mit einem Atomgewicht bis zu 80 sein können,

X für die Atome O oder S steht, und

n die Zahlen 0 oder 1 bedeuten kann,

(b) eine oder mehrere übliche polymerisierbare olefinisch ungesättigte organische Verbindungen sowie als weitere Zusätze

(c) mindestens ein Na$^-$, K– oder Li-Salz einer organischen Säure mit mindestens 4 Kohlenstoffatomen und

(d) mindestens ein Lösungsmittel für Komponente (c), wobei das Lösungsmittel (d) mindestens in einer solchen Menge vorliegt, die ausreicht, Komponente (c) vollständig zu lösen.

Gegenstand der vorliegenden Erfindung ist ferner die Verwendung dieser photopolymerisierbaren Massen zur Herstellung von Überzügen, Photopolymerdruckplatten und UV-härtenden Druckfarben.

Zu den Aufbaukomponenten der erfindungsgemäßen photopolymerisierbaren Massen ist im einzelnen folgendes zu sagen :

(a) Als Photoinitiatoren (a) kommen Acylphosphinverbindungen der oben definierten allgemeinen Formel (I)

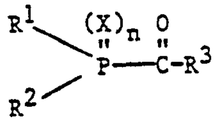

in Betracht, vorzugsweise Acylphosphinoxide und Acylphosphinsulfide.

Geeignete Acylphosphinoxide sind in den EP 42 567, DE-OS 28 30 927, DE-OS 29 09 994, DE-OS 30 20 092, DE-OS 30 34 697 sowie in den deutschen Patentanmeldungen P 31 14 341 und P 31 33 419 beschrieben. Als besonders geeignete Verbindungen (a) seien genannt :

2,4,6-Trimethylbenzoyldiphenylphosphinoxid,
2,4,6-Trimethylbenzoylphenylphosphinsäureethylester,
2,4,6-Trimethylbenzoyl-bis(o-tolyl) phosphinoxid,
2,6-Dimethyl-4-tert.-butylbenzoylmethylphosphinsäureisopropylester und
2,4,6-Trimethylbenzoyl-diphenylphosphinsulfid

(b) Als polymerisierbare olefinisch ungesättige organische Verbindungen (b) eignen sich die üblichen photopolymerisierbaren Monomeren, d. h. die üblichen Verbindungen und Stoffe mit polymerisierbaren C-C-Doppelbindungen, die durch z. B. Aryl-, Carbonyl-, Amino-, Amid-, Amido-, Ester-, Carboxy- oder Cyanid-Gruppen, Halogenatome oder C-C-Doppel- oder C-C-Dreifachbindungen aktiviert sind. Genannt seien beispielsweise Vinylether und Vinylester, Styrol, Vinyltoluol, Acrylsäure und Methacrylsäure sowie deren Ester mit ein- und mehrwertigen Alkoholen, deren Nitrile oder Amide, Malein- und Fumarester sowie N-Vinylpyrrolidon, N-Vinylcaprolactam, N-Vinylcarbazol und Allylester wie Diallylphthalat.

Als polymerisierbare höhermolekulare Verbindungen (b) sind beispielsweise geeignet : ungesättigte Polyester, hergestellt aus α,β-ungesättigten Dicarbonsäuren oder deren Anhydriden, wie Maleinsäure, Maleinsäureanhydrid, Fumarsäure oder Itaconsäure, ggf. im Gemisch mit gesättigten bzw. aromatischen Dicarbonsäuren oder deren Anhydriden, wie Adipinsäure, Phthalsäure, Phthalsäureanhydrid, Tetrahydrophthalsäure oder Terephthalsäure, durch Umsetzung mit Alkandiolen wie Ethylenglykol, Propylenglykol, Butandiol, Neopentylglykol oder oxalkyliertem Bisphenyl-A ; Epoxidacrylate, hergestellt aus Acryl- oder Methacrylsäure und aromatischen oder aliphatischen Glycidylethern, Polyesteracrylate (z. B. hergestellt aus hydroxylgruppenhaltigen gesättigten Polyestern und Acryl- oder Methacrylsäure) und Urethanacrylate. Desgleichen eignen sich Gemische der genannten Verbindungen (b).

(c) Als Na-, K-, oder Li-Salze organischer Säuren mit mindestens 4 Kohlenstoffatomen (c) eignen sich die Salze von Carbonsäuren, Sulfonsäuren, Sulfinsäuren, teilveresterten Schwefelsäuren oder Phosphonsäuren sowie von Phosphon- oder Phosphinsäuren sowie ferner die aus der deutschen Patentanmeldung P 31 14 341 bekannten Salze der Acylphosphinsäuren und Acylphosphonsäuren.

Beispiele solcher Salze sind die Kalium, Natrium- oder Lithiumsalze von Valeriansäure, 2-Ethylhexansäure, Capronsäure, Laurinsäure, Palmitinsäure, Ölsäure, Stearinsäure, Adipinsäure, von Dodecylbenzolsulfonsäure, p-Toluolsulfonsäure sowie der mit Laurylalkohol, Stearylalkohol oder Butyltriglykol teilveresterten Schwefelsäuren, von sulfoniertem Erdnuß- und Sojaöl sowie von Di-2-ethylhexylphosphorsäure. Desgleichen eignen sich Gemische der genannten organischen Säuren. Die als Komponente (c) zu verwendende organische Säure enthält mindestens 4, vorzugsweise 4 bis 20, insbesondere 6 bis 18 Kohlenstoffatome.

Besonders gut geeignet ist Lithiumoctylsulfonat.

(d) Als Lösungsmittel (d) sind niedere Alkohole wie Methanol oder Ethanol, vorzugsweise jedoch Wasser geeignet.

Das Initiatorsystem enthält im allgemeinen auf 1 Gewichtsteil der Komponente (a) 0,05 bis 5 Gewichtsteile, vorzugsweise 0,1 bis 2 Gewichtsteile, der Komponente (c) und 0,1 bis 50 Gewichtsteile, vorzugsweise 0,1 bis 10 Gewichtsteile der Komponente (d). Die Summe der Komponenten (a), (c) und (d) beträgt 0,5 bis 50 Gewichtsprozent, vorzugsweise 1 bis 10 Gewichtsprozent, bezogen auf Komponente (b).

In einer Ausführungsform der Erfindung sind die Komponenten (a), (c) und (d) in Komponente (b) homogen gelöst. Dazu ist in der Regel der Einsatz sehr polarer Bindemittel erforderlich. In einer anderen Ausführungsform der Erfindung wird Komponente (c) in Komponente (d) gelöst und die erhaltene Lösung in einer Lösung von Komponente (a) im Bindemittel (b) durch Einwirkung von Scherkräften, z. B. durch Rühren emulgiert.

Die erfindungsgemäße Kombination des Initiators (a) mit den Komponenten (b) und (c) zeigt eine sehr gute Reaktivität bei der Härtung von photopolymerisierbaren Monomeren (b) mit mindestens einer C-C-Mehrfachbindung und Mischungen derselben miteinander und mit bekannten Zusatzstoffen. Insbesondere die bevorzugten orthodisubstituierten Aroyldiphenylphosphinoxide bzw. Aroyl-phenylphosphinsäureester besitzen darin als Komponente (a) eine ausgezeichnete Lagerstabilität. Mit der erfindungsgemäßen Initiatorkombination lassen sich wesentlich höhere Härtungsgeschwindigkeiten erzielen als mit der in EP 37 152 und EP 37 604 beschriebenen. Ferner lassen sich mit der erfindungsgemäßen Initiatorkombination auch weiß pigmentierte Lacke vergilbungsfrei aushärten sowie bunt pigmentierte Lacke verarbeiten. Dies ist mit den in EP 37 152 und EP 37 604 beschriebenen Kombinationen nicht möglich. Die mit den erfindungsgemäßen Massen erzielbaren Härtungsgeschwindigkeiten sind wesentlich höher als die mit den reinen Komponenten (a) gemäß EP 42 567, DE-OS 28 30 927, DE-OS 30 20 092, DE-OS 30 34 697 sowie der deutschen Patentanmeldungen P 31 14 341 und P 31 33 419 erzielbaren.

Gegebenenfalls können die erfindungsgemäßen photopolymerisierbaren Überzugsmittel, Lacke und Druckfarben auch als wäßrige Dispersionen vorliegen oder zur Anwendung gebracht werden.

Den photopolymerisierbaren Verbindungen (b), deren Zusammensetzung für den jeweiligen Vewendungszweck dem Fachmann geläufig ist, können in bekannter Weise gesättigte und/oder ungesättigte Polymere sowie weitere Zusatzstoffe wie Inhibitoren gegen die thermische Polymerisation, Paraffin, Pigmente, Farbstoffe, Peroxide, Verlaufshilfsmittel, Füllstoffe und Mattierungsmittel sowie Stabilisatoren gegen thermischen oder photochemischen Abbau zugesetzt sein. Weitere mögliche Zusatzstoffe sind tertiäre Amine wie z. B. Triethanolamin, Methyldiethanolamin und Ester der p-Dimethylaminobenzoesäure, beispielsweise in Mengen von 0,1 bis 10 Gewichtsprozent, bezogen auf die Summe der Komponenten (a) bis (d).

Als Strahlungsquellen für das die Polymerisation solcher Mischungen auslösende Licht verwendet man zweckmäßigerweise solche, die Licht vorzugsweise im Absorptionsbereich der erfindungsgemäßen Verbindungen (a) aussenden, d. h. zwischen 230 und 450 nm. Besonders geeignet sind Quecksilber-Niederdruckstrahler, Mitteldruck- und Hochdruckstrahler sowie Leuchtstoffröhren oder Impulsstrahler. Die genannten Lampen können ggf. dotiert sein.

Die in den nachstehenden Beispielen genannten Teile und Prozente beziehen sich, soweit nicht anders angegeben auf das Gewicht. Volumenteile verhalten sich zu Teilen wie Liter zu Kilogramm.

## Beispiel 1

In einem Bindemittel aus 65 Teilen eines Umsetzungsproduktes aus Bisphenol-A-Diglycidylether und Acrylsäure im Molverhältnis 1 : 2 und 35 Teilen Hexandiol-1,6-diacrylat wurden 3 Teile der angegebenen Photoinitiatoren gelöst und anschließend 5 Teile einer 20 prozentigen wäßrigen Lösung von Lithiumoctylsulfonat durch Rühren emulgiert. Die Mischung wird auf Glasplatten in einer Schicht von 80 µm aufgerakelt und in 10 cm Abstand unter einer Quecksilberhochdrucklampe (Leistung 80 W/cm Bogenlänge) vorbeigeführt. Die Ergebnisse sind in Tabelle 1 zusammengestellt. Es wurden folgende Initiatoren eingesetzt:

I 2,4,6-Trimethylbenzoyldiphenylphosphinoxid nach DE-OS 29 09 994
II Benzildimethylketal
III α-Methylolbenzoinmethansulfonsäuremethylester nach EP 37 152
IV 1-Phenyl-2-hydroxy-2-methylpropan
V 2,4,6-Trimethylbenzoylphenylphosphinsäureethylester
VI 2,4,6-Trimethylbenzoylphosphonsäuredimethylester

Tabelle 1

| Versuch-Nr. | Initiator | Zusatz von Lithium-sulfonat | weitere Zusätze | maximale Härtungsgeschwindigkeit zur Erzielung einer kratzfesten Beschichtung m/min |
|---|---|---|---|---|
| 1 | I | nein | - | < 14 |
| 2 | I | nein | 3 % Methyldiethanolamin | 50 |
| 3 | I | ja | - | 150 |
| 4 | II | ja | - | 100 |
| 5 | III | ja | - | 100 |
| 6 | IV | ja | - | 72 |
| 7 | V | ja | - | 150 |
| 8 | VI | nein | - | < 14 |
| 9 | VI | nein | 3 % Methyldiethanolamin | 15 |
| 10 | VI | ja | - | 80 |

**Patentansprüche**

1. Photopolymerisierbare Masse auf Basis eines Gemisches aus Photoinitiator, polymerisierbaren olefinisch ungesättigten organischen Verbindungen und weiteren Zusätzen, dadurch gekennzeichnet, daß sie enthält

(a) als Photoinitiator eine Acylphosphinverbindung der allgemeinen Formel (I)

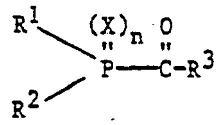 (I)

wobei

$R^1$ für einen geradkettigen oder verzweigten Alkyl- oder Alkenylrest mit bis zu 8 Kohlenstoffatomen, für einen geradkettigen oder verzweigten Alkoxy- oder Alkenyloxyrest mit bis zu 8 Kohlenstoffatomen, einen Cyclohexyl, Cyclopentyl- oder Benzylrest, einen Cyclopentyloxy-, Cyclohexyloxy- oder Benzyloxyrest oder für einen bis zu dreifach substituierten Phenyl- oder Phenyloxyrest steht, wobei die Substituenten geradkettige oder verzweigte, bis zu 6 Kohlenstoffatome enthaltende Alkyl-, Alkoxy-, Alkylthio-, Dialkylaminogruppen oder Halogenatome mit einem Atomgewicht bis zu 80 sein können,

$R^2$ die gleiche Bedeutung wie $R^1$ hat, wobei $R^1$ und $R^2$ untereinander gleich oder verschieden sind, oder für die Gruppierung $NR^4R^5$ steht, wobei $R^4$

und $R^5$ untereinander gleich oder verschieden sind und für Wasserstoff, einen geradkettigen oder verzweigten Alkylrest mit bis zu 18 C-Atomen, einen Cyclohexyl-, Cyclopentylrest, einen Hydroxyalkylrest mit 2 bis 4 Kohlenstoffatomen oder einen Phenylrest stehen,

$R^3$ für einen tertiären Alkylrest mit 4 bis 18 C-Atomen, einen tertiären Cycloalkylrest mit 6 bis 18 C-Atomen oder für einen gegebenenfalls ein- bis vierfach substituierten Pyridyl-, Pyrrolyl-, Furyl-, Thienyl-, Phenyl- oder Naphthylrest steht, dessen Substituenten untereinander gleich oder verschieden sein können und bis zu 6 Kohlenstoffatome enthaltende, geradkettige oder verzweigte Alkyl-, Alkoxy-, oder Alkylthio-Reste, 5 bis 7 Kohlenstoffatome enthaltende Cycloalkylreste, Phenylreste, Nitril-, Carboxyl-, Carboalkoxygruppen oder Halogenatome mit einem Atomgewicht bis zu 80 sein können,

X für die Atome O oder S steht und

n die Zahlen 0 oder 1 bedeuten kann,

(b) eine oder mehrere übliche polymerisierbare olefinisch ungesättigte organische Verbindungen sowie als weitere Zusätze

(c) mindestens ein Na$^-$, K$^-$ oder Li-Salz einer organischen Säure mit mindestens 4 Kohlenstoffatomen und

(d) mindestens ein Lösungsmittel für Komponente (c), wobei das Lösungsmittel (d) mindestens in einer solchen Menge vorliegt, die ausreicht, Komponente (c) vollständig zu lösen.

2. Photopolymerisierbare Masse nach Anspruch 1, dadurch gekennzeichnet, daß der Rest $R^3$ der als Photoinitiator (a) verwendeten Acylphosphinverbindung ein Phenylring ist, der mindestens in den beiden zur Verknüpfung mit der Carbonylgruppe benachbarten Stellungen substituiert ist, wobei die Substituenten die in Anspruch 1 gegebene Bedeutung haben.

3. Photopolymerisierbare Masse nach Anspruch 1, dadurch gekennzeichnet, daß das Salz (c) das Salz einer Acylphosphinsäure, einer gegebenenfalls teilveresterten Acylphosphonsäure, einer Sulfonsäure, Carbonsäure, Sulfinsäure, Phosphinsäure, einer teilveresterten Schwefel- oder Phosphorsäure oder einer gegebenenfalls teilveresterten Phosphonsäure ist.

4. Photopolymerisierbare Masse nach einem der vorhergehenden Ansprüche, dadurch gekennzeichnet, daß sie auf 1 Gewichtsteil der Komponente (a) 0,05 bis 5 Gewichtsteile der Komponente (c) und 0,1 bis 50 Gewichtsteile der Komponente (d) enthält und die Summe der Komponenten (a), (c) und (d) 0,5 is 50 Gewichtsprozent der Komponente (b) beträgt.

5. Photopolymerisierbare Masse nach einem der vorhergehenden Ansprüche, dadurch gekennzeichnet, daß als Lösungsmittel (d) Wasser verwendet wird.

6. Photopolymerisierbare Masse nach einem der vorhergehenden Ansprüche, dadurch gekennzeichnet, daß als Komponente (c) das Salz einer längerkettigen organischen Säure mit 4 bis 20 C-Atomen in der Alkylkette verwendet wird.

7. Photopolymerisierbare Masse nach einem der vorhergehenden Ansprüche, dadurch gekennzeichnet, daß sie eine homogene Lösung oder eine Emulsion der Komponenten (c) und (d) in einer Lösung der Komponente (a) in (b) darstellt.

8. Photopolymerisierbare Masse nach einem der vorhergehenden Ansprüche, dadurch gekennzeichnet, daß sie zusätzlich sekundäre oder tertiäre Amine in einer Konzentration von 0,1 bis 10 Gewichtsprozent, bezogen auf die Summe der Komponenten (a) bis (d), enthält.

9. Verwendung der photopolymerisierbaren Masse nach einem der vorhergehenden Ansprüche zur Herstellung von Überzügen.

10. Verwendung der photopolymerisierbaren Masse nach einem der Ansprüche 1 bis 8 zur Herstellung von Photopolymerdruckplatten.

11. Verwendung der photopolymerisierbaren Masse nach einem der Ansprüche 1 bis 8 zur Herstellung von UV-härtenden Druckfarben.

## Claims

1. A photopolymerizable composition based on a mixture of a photoinitiator, polymerizable olefinically unsaturated organic compounds and further additives, characterized in that it contains

(a), as photoiniatiator, an acylphosphine compound of the general formula (I)

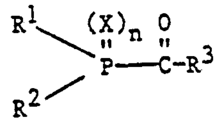

(I)

where

$R^1$ is linear or branched alkyl or alkenyl of up to 8 carbon atoms, linear or branched alkoxy or alkenyloxy of up to 8 carbon atoms, cyclohexyl, cyclopentyl, benzyl, cyclopentyloxy, cyclohexyloxy, benzyloxy, unsubstituted or mono-, di- or trisubstituted phenyl or phenyloxy, the substituents being linear or branched alkyl, alkoxy, alkylthio or dialkylamino groups of up to 6 carbon atoms, or halogen atoms having an atomic weight of up to 80,

$R^2$ has the same meanings as $R^1$, $R^1$ and $R^2$ being identical or different, or stands for the group $NR^4R^5$, where $R^4$ and $R^5$ are identical or different and each denotes hydrogen, linear or branched alkyl of up to 18 carbon atoms, cyclohexyl, cyclopentyl, or hydroxyalkyl of 2 to 4 carbon atoms, or phenyl,

$R^3$ is tertiary alkyl of 4 to 18 carbon atoms, tertiary cycloalkyl of 6 to 18 carbon atoms, or pyridyl, pyrrolyl, furyl, thienyl, phenyl or naphthyl optionally bearing 1 to 4 substituents which may be identical or different and are each linear or branched alkyl, alkoxy or alkylthio of up to 6 carbon atoms, cycloalkyl, phenyl, nitrilo, carboxyl or carbalkoxyl of 5 to 7 carbon atoms, or a halogen atom having an atomic weight of up to 80,

X is O or S, and

n is 0 or 1,

(b) one or more conventional polymerizable olefinically unsaturated organic compounds and, as further additives,

(c) at least one Na, K or Li salt of an organic acid of at least 4 carbon atoms, and

(d) at least one solvent for component (c), the solvent (d) being present in at least an amount which is sufficient to completely dissolve component (c).

2. A photopolymerizable composition as claimed in claim 1, characterized in that the radical $R^3$ of the acylphosphine compound used as photoinitiator (a) is a phenyl ring which is substituted at least in the two positions adjacent to the carbonyl group, the substituents having the meanings given in claim 1.

3. A photopolymerizable composition as claimed in claim 1, characterized in that the salt (c) is the salt of an acylphosphinic acid, an optionally partially esterified acylphosphonic acid, a sulfonic acid, a carboxylic acid, a sulfinic acid, a phosphinic acid, partially esterified sulfuric or phosphoric acid, or an optionally partially esterified phosphonic acid.

4. A photopolymerizable composition as claimed in any of the preceding claims, characterized in that it contains from 0.05 to 5 parts by weight of component (c) and from 0.1 to 50 parts by weight of component (d) per part by weight of component (a), and the sum of components (a), (c) and (d) amounts to from 0.5 to 50 % by weight of component (b).

5. A photopolymerizable composition as claimed in any of the preceding claims, characterized in that water is used as solvent (d).

6. A photopolymerizable composition as claimed in any of the preceding claims, characterized in that the salt of a relatively long-chain organic acid having 4 to 20 carbon atoms in the alkyl chain is used as component (c).

7. A photopolymerizable composition as claimed in any of the preceding claims, characterized in that it constitutes a homogeneous solution or an emulsion of components (c) and (d) in a solution of component (a) in (b).

8. A photopolymerizable composition as claimed in any of the preceding claims, characterized in that it additionally contains secondary or tertiary amines in an amount of from 0.1 to 10 % by weight, based on the sum of components (a) to (d).

9. The use of a photopolymerizable composition as claimed in any of the preceding claims for the production of coatings.

10. The use of a photopolymerizable composition as claimed in any of claims 1 to 8 for the production of photopolymer printing plates.

11. The use of a photopolymerizable composition as claimed in any of claims 1 to 8 for the production of UV-curing printing inks.

**Revendications**

1. Composition photopolymérisable à base d'un mélange de composés organiques à insaturation oléfinique polymérisables, d'un photo-amorceur et d'autres additifs, caractérisée en ce qu'elle contient

(a) comme photo-amorceur un composé acyl-phosphinique de la formule générale

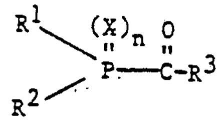

(I)

dans laquelle

$R^1$ désigne un radical alkyle ou alcényle à chaîne droite ou ramifiée, comprenant jusqu'à huit atomes de carbone, un radical alcoxy ou alcényloxy à chaîne droite ou ramifiée, comportant jusqu'à huit atomes de carbone, un groupe cyclopentyle, cyclohexyle ou benzyle, un reste cyclopentyloxy, cyclohexyloxy ou benzyloxy, ou un groupe phényle ou phényloxy mono- à tri-substitué par des groupes alkyle, alcoxy, alkyl-thio ou dialkyl-amino à chaîne droite ou ramifiée avec jusqu'à six atomes de carbone ou par des atomes d'halogène d'un poids atomique ne dépassant pas 80,

$R^2$ possède les mêmes significations que $R^1$, $R^1$ et $R^2$ pouvant être identiques ou différents, ou représente un groupement $NR^4R^5$, dans lequel $R^4$ et $R^5$, qui peuvent être identiques ou différents, désignent chacun un atome d'hydrogène, un radical alkyle à chaîne droite ou ramifiée avec jusqu'à 18 atomes de carbone, un groupe cyclopentyle ou cyclohexyle, un radical hydroxy-alkyle en $C_2$ à $C_4$ ou un groupe phényle,

$R^3$ représente un radical alkyle tertiaire en $C_4$ à $C_{18}$, un groupe cycloalkyle tertiaire en $C_6$ à $C_{18}$ ou un groupe pyridyle, pyrrolyle, furyle, thiényle, phényle ou naphtyle, pouvant être mono- à tétra-substitué par des substituants identiques ou différents, choisis parmi les radicaux alkyle, alcoxy et alkyl-thio à chaîne droite ou ramifiée, comportant jusqu'à six atomes de carbone, les groupes cycloalkyle en $C_5$ à $C_7$, phényle, nitrile, carboxyle et carbalcoxy et les atomes d'halogène d'un poids atomique ne dépassant pas 80,

X représente un atome d'oxygène ou de soufre et n vaut 0 ou 1 ;

(b) un ou plusieurs composés organiques à insaturation oléfinique polymérisables habituels et d'autres additifs ;

(c) au moins un sel du sodium, du potassium ou du lithium d'un acide organique en $C_4$ et plus ;

(d) au moins un solvant pour le composant (c) en une proportion suffisante pour assurer la dissolution complète du composant (c).

2. Composition photopolymérisable suivant la revendication 1, caractérisée en ce que le substituant $R^3$ du dérivé acyl-phosphinique employé comme photo-amorceur (a) est un noyau phényle, substitué au moins sur les deux positions voisines du groupe carbonyle par des substituants tels que définis dans la revendication 1.

3. Composition photopolymérisable suivant la revendication 1, caractérisée en ce que le sel (c) est le sel d'un acide acyl-phosphinique, d'un acide acyl-phosphonique éventuellement partiellement saponifié, d'un acide sulfonique, d'un acide carboxylique, d'un acide sulfinique, d'un acide phosphinique, d'un acide sulfurique ou phosphorique partiellement estérifié ou d'un acide phosphonique pouvant être partiellement estérifié.

4. Composition photopolymérisable suivant l'une des revendications précédentes, caractérisée en ce qu'elle contient, pour une partie en poids de la composante (a), entre 0,05 et 5 parties en poids de composante (c) et entre 0,1 et 50 parties en poids de composante (d) et la somme des composantes (a), (c) et (d) représente entre 0,5 et 50 % du poids de la composante (b).

5. Composition photopolymérisable suivant l'une des revendications précédentes, caractérisée en ce que l'eau est utilisée comme solvant (d).

6. Composition photopolymérisable suivant l'une des revendications précédentes, caractérisée en ce que la composante (c) est le sel d'un acide organique à longue chaîne, dont la chaîne alkyle comprend entre quatre et vingt atomes de carbone.

7. Composition photopolymérisable suivant l'une des revendications précédentes, caractérisée en ce qu'elle est constituée d'une solution homogène ou d'une émulsion des composantes (c) et (d) dans une solution de la composante (a) dans la composante (b).

8. Composition photopolymérisable suivant l'une des revendications précédentes, caractérisée en ce qu'elle contient en outre entre 0,1 et 10 % en poids, par rapport à la somme des poids des composantes (a) à (d), d'amines secondaires ou tertiaires.

9. Utilisation d'une composition photopolymérisable suivant l'une des revendications précédentes pour la réalisation de revêtements.

10. Utilisation d'une composition photopolymérisable suivant l'une des revendications 1 à 8 pour la fabrication de plaques d'impression.

11. Utilisation d'une composition photopolymérisable suivant l'une des revendications 1 à 8 pour la préparation d'encres d'impression durcissant sous l'effet de la lumière ultra-violette.